# EUROPEAN PATENT APPLICATION

(11) **EP 4 590 105 A1**
(43) Date of publication of application: **23.07.2025**
(21) Application number: 25151967.4
(22) Date of filing: 15.01.2025
(51) Int. Cl.: H10K 59/80, H10K 50/858, H10K 50/844, H10K 102/00

(54) **DISPLAY DEVICE AND MANUFACTURING METHOD OF THE SAME**

(30) Priority: 17.01.2024 KR 20240007482
(71) Applicant: Samsung Display Co., Ltd., Gyeonggi-Do (KR)
(72) Inventor: Kim, Jungi, Yongin-si, Gyeonggi-Do (KR); Ryu, Younjoo, Yongin-si, Gyeonggi-Do (KR); Yun, Sanghyun, Yongin-si, Gyeonggi-Do (KR); Lee, Jaehun, Yongin-si, Gyeonggi-Do (KR); Jung, Hyunyoung, Yongin-si, Gyeonggi-Do (KR); Cha, Gwangmin, Yongin-si, Gyeonggi-Do (KR)
(74) Representative: Gulde & Partner

(57) **Abstract**

Provided is a display device including a display panel and a light-path control layer disposed on the display panel to control a path of light provided from the display panel, the light-path control layer includes a plurality of horizontal walls arranged in a first direction and extending in a second direction perpendicular to the first direction, a first transmission part disposed between the plurality of horizontal walls and having a thickness smaller than a height of each of the plurality of horizontal walls, and a light-collecting part disposed between the plurality of horizontal walls and disposed on the first transmission part, and an upper surface of the light-collecting part is concave toward the first transmission part.

## Description

### BACKGROUND

### 1. Technical Field

Embodiments relate to a display device and a manufacturing method of the display device, and more particularly, to a display device including a light-path control layer and a manufacturing method of the display device.

### 2. Description of the Related Art

Display devices used for various apparatuses, such as a television, a mobile phone, a tablet computer, and a vehicle, are being developed. According to the user environment where information protection is needed, or according to the safety regulations, limiting the viewing angle of the display device has been required. Therefore, research on the limitation of the viewing angle is in progress.

### SUMMARY

Embodiments provide a display device capable of improving viewing angle limitation characteristics and improving front light-emitting efficiency.

Embodiments also provide a manufacturing method of a display device capable of improving process efficiency.

However, embodiments are not limited to those set forth herein. The above and other embodiments will become more apparent to one of ordinary skill in the art to which the disclosure pertains by referencing the detailed description of the disclosure given below.

An embodiment provides a display device including a display panel, and a light-path control layer disposed on the display panel to control a path of light provided from the display panel, wherein the light-path control layer may include a plurality of horizontal walls arranged in a first direction and extending in a second direction perpendicular to the first direction, a first transmission part disposed between the plurality of horizontal walls, and having a thickness smaller than a height of each of the plurality of horizontal walls, and a light-collecting part disposed between the plurality of horizontal walls on the first transmission part, and an upper surface of the light-collecting part may be concave toward the first transmission part.

In an embodiment, each of the first transmission part and the light-collecting part may have a refractive index of about 1.4 to about 1.5, preferably 1,45.

In an embodiment, the display device may further include a second transmission part disposed on the light-collecting part.

In an embodiment, the second transmission part may have a refractive index greater than a refractive index of the first transmission part and a refractive index of the light-collecting part.

In an embodiment, the second transmission part may have a refractive index of about 1.55 to about 1.8, preferably 1.6 to 1.7, or 1.65.

In an embodiment, the display device may further include a transparent protection film disposed between the plurality of horizontal walls and the first transmission part and between the plurality of horizontal walls and the display panel, wherein the transparent protection film may include an inorganic film.

In an embodiment, the transparent protection film may extend an area between the first transmission part and the light-collecting part.

In an embodiment, a display device may include a display panel, and a light-path control layer disposed on the display panel to control a path of light provided from the display panel, the light-path control layer may include a plurality of vertical walls extending in a first direction and arranged in a second direction perpendicular to the first direction, a first transmission part disposed between the plurality of vertical walls, and a light-collecting part disposed between the plurality of vertical walls on the first transmission part, and an upper surface of the light-collecting part may be concave toward the first transmission part, or may be convex in an opposite direction of a direction toward the first transmission part.

In an embodiment, each of the first transmission part and the light-collecting part may have a refractive index of about 1.4 to about 1.5.

In an embodiment, the display device may further include a second transmission part disposed on the light-collecting part.

In an embodiment, the second transmission part may have a refractive index greater than a refractive index of the first transmission part and a refractive index of the light-collecting part.

In an embodiment, the second transmission part may have a refractive index of about 1.55 to about 1.8.

In an embodiment, the display panel may include a first-type light-emitting element, and a second-type light-emitting element spaced apart from the first-type light-emitting element in the second direction, the plurality of vertical walls may include a plurality of first vertical walls not overlapping the first-type light-emitting element and the second-type light-emitting element, and having a height greater than a thickness of the first transmission part, and a plurality of second vertical walls overlapping the first-type light-emitting element and not overlapping the second-type light-emitting element, and having a height greater than the thickness of the first transmission part, the light-collecting part may be disposed between the plurality of first vertical walls and the plurality of second vertical walls, and the upper surface of the light-collecting part may be concave toward the first transmission part.

In an embodiment, the light-collecting part may at least partially overlap the first-type light-emitting element and may not overlap the second-type light-emitting element.

In an embodiment, the light-collecting part may include a first light-collecting part at least partially overlapping the first-type light-emitting element and not overlapping the second-type light-emitting element, and a second light-collecting part overlapping the first-type light-emitting element and the second-type light-emitting element.

In an embodiment, the display panel may include a first-type light-emitting element, and a second-type light-emitting element spaced apart from the first-type light-emitting element in the second direction, the plurality of vertical walls may include a plurality of first vertical walls not overlapping the first-type light-emitting element and the second-type light-emitting element, and having a height greater than a thickness of the first transmission part, and a plurality of second vertical walls overlapping the first-type light-emitting element and not overlapping the second-type light-emitting element, and having a height same as the thickness of the first transmission part, the light-collecting part may be disposed between the plurality of first vertical walls, and the upper surface of the light-collecting part may be concave toward the first transmission part.

In an embodiment, the display panel may include a first-type light-emitting element and a second-type light-emitting element spaced apart from the first-type light-emitting element in the second direction, the light-path control layer may further include a second transmission part disposed on the light-collecting part, the plurality of vertical walls may include a plurality of first vertical walls not overlapping the first-type light-emitting element and the second-type light-emitting element, and having a height greater than a thickness of the first transmission part, and a plurality of second vertical walls overlapping the first-type light-emitting element and not overlapping the second-type light-emitting element, and having a height same as the thickness of the first transmission part, the light-collecting part may be disposed between the plurality of first vertical walls, the upper surface of the light-collecting part may be convex toward the second transmission part, and a refractive index of the light-collecting part may be greater than a refractive index of the second transmission part.

In an embodiment, a manufacturing method of a display device may include preparing a display panel, forming, on the display panel, a first transmission part including a plurality of grooves extending in a first direction and arranged in a second direction perpendicular to the first direction, forming a plurality of light-blocking walls at a height higher than the first transmission part in a region corresponding to the plurality of grooves of the first transmission part, forming a light-collecting part, including a concave upper surface recessed toward the first transmission part, between the plurality of light-blocking walls on the first transmission part, and forming, on the light-collecting part, a second transmission part having a refractive index greater than a refractive index of the first transmission part, and the forming of the plurality of light-blocking walls may include applying a light-blocking material on the first transmission part to fill the plurality of grooves, and patterning the plurality of light-blocking walls in the region corresponding to the plurality of grooves by a photoresist process or a hard mask patterning process.

In an embodiment, the manufacturing method may further include depositing an inorganic material to form a transparent protection film covering the plurality of grooves of the first transmission part and an upper surface of the first transmission part.

In an embodiment, each of the first transmission part and the light-collecting part may have a refractive index of about 1.4 to about 1.5, preferably 1.45, and the second transmission part may have a refractive index of about 1.55 to about 1.8, preferably 1.6 to 1.7, or 1.65.

### BRIEF DESCRIPTION OF THE DRAWINGS

The accompanying drawings are included to provide a further understanding of the invention, and are incorporated in and constitute a part of the description. The drawings illustrate embodiments and, together with the description, serve to explain principles of the invention. In the drawings:
FIG. 1 is a schematic view illustrating an interior of a vehicle where a display device, according to an embodiment, is disposed;
FIG. 2A is a schematic view illustrating an image viewed from a driver's seat in case that a display device, according to an embodiment, operates in a first mode;
FIG. 2B is a schematic view illustrating an image viewed from a driver's seat in case that a display device, according to an embodiment, operates in a second mode;
FIG. 2C is a schematic view schematically illustrating a viewing angle of an image of a display device according to an embodiment;
FIGS. 3A and 3B are schematic cross-sectional views each illustrating a display device according to an embodiment;
FIG. 4 is a block diagram of a display device according to an embodiment;
FIG. 5 is an enlarged schematic plan view of a first display region according to an embodiment;
FIGS. 6A to 6C are schematic cross-sectional views each illustrating a portion of a first display region according to an embodiment;
FIG. 7 is an enlarged schematic plan view of a second display region according to an embodiment;
FIGS. 8A to 8D are schematic cross-sectional views each illustrating a portion of a second display region according to an embodiment; and
FIGS. 9A to 9H and FIGS. 10A to 10E are schematic cross-sectional views each illustrating one step of a manufacturing method of a display device according to an embodiment.

### DETAILED DESCRIPTION OF THE EMBODIMENTS

Embodiments will be described below in more detail with reference to the accompanying drawings. The invention may, however, be embodied in different forms and should not be construed as limited to the embodiments set forth herein. Rather, these embodiments are provided so that this disclosure will be thorough and complete, and will fully convey the scope of the invention to those skilled in the art.

In the description, the singular forms, "a", "an" and "the" are intended to include the plural forms as well, unless the context clearly indicates otherwise.

It will be further understood that the terms "includes" and/or "have", when used in the description, specify the presence of stated features, integers, steps, operations, elements, and/or components, but do not preclude the presence or addition of one or more other features, integers, steps, operations, elements, components, and/or groups thereof.

In the description, it will be understood that when an element (or a region, a layer, a portion, or the like) is referred to as being "on", "connected to" or "coupled to" another element, it may be directly disposed on, connected or coupled to the other element, or intervening elements may be disposed therebetween.

In the description, terms of "below", "on lower side", "above", "on upper side", or the like may be used to describe the relationships of the elements illustrated in the drawings. These terms have relative concepts and are described on the basis of the directions indicated in the drawings.

In the description, the term "disposed on" may be referred to as being disposed not only on an upper part of one member but also being disposed on a lower part thereof.

In the description, the term "directly disposed" may mean there is no additional layer, film, region, substrate, or the like between one layer, film, region, substrate, or the like and the other. For example, the term "directly disposed" may be referred to as being disposed between two layers or two members without using an additional member such as an adhesion member.

In the description, the term "and/or" includes any and all combinations of one or more of the associated listed items.

In the description, it will be understood that, although the terms first, second, etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the scope of the invention. Similarly, a second element, component, region, layer or section may be termed a first element, component, region, layer or section.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Like reference numerals or symbols refer to like elements throughout. In the drawings, the thickness, the ratio, and the size of the element are exaggerated for effective description of the technical contents.

Hereinafter, a display device and a manufacturing method of the same, according to embodiment, are described with reference to the accompanying drawings.

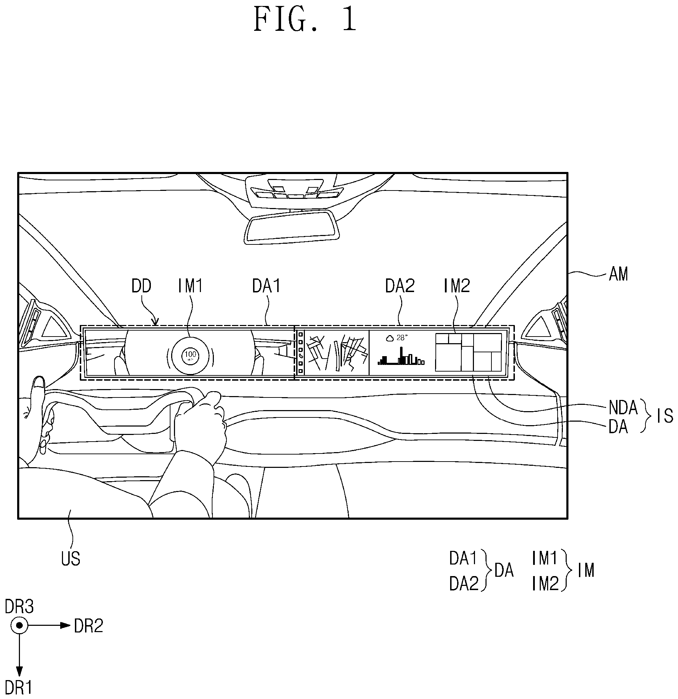

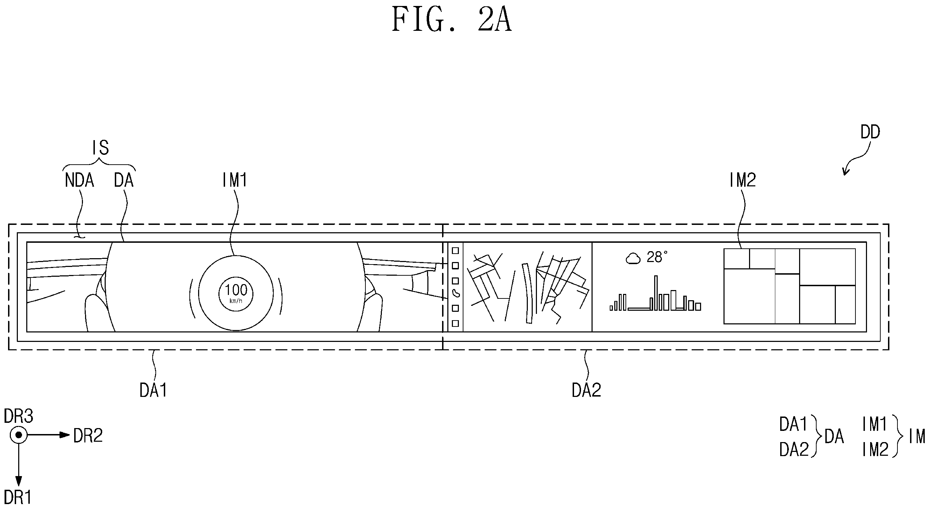

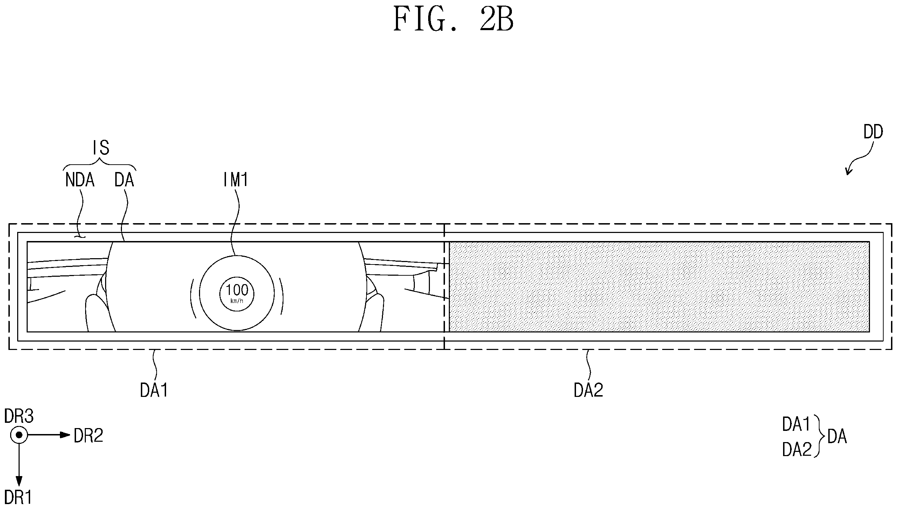

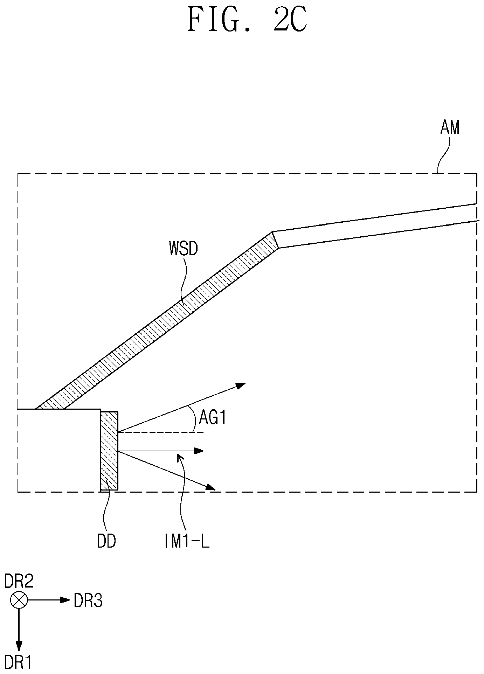

FIG. 1 is a schematic view illustrating an interior of a vehicle AM where a display device DD, according to an embodiment, is disposed. FIG. 2A is a schematic view illustrating images IM1 and IM2 viewed from a driver's seat in case that the display device DD, according to an embodiment, operates in a first mode. FIG. 2B is a schematic view illustrating the image IM1 viewed from the driver's seat in case that the display device DD, according to an embodiment, operates in a second mode. FIG. 2C is a schematic view schematically illustrating a viewing angle AG1 of the image IM1 of the display device DD according to an embodiment.

Referring to FIG. 1, the display device DD according to an embodiment may be disposed inside the vehicle AM. The display device DD may be activated in response to electrical signals. The display device DD may be applied to electronic apparatuses such as a mobile phone, a tablet computer, a smart watch, a laptop computer, a computer, and a smart television. The display device DD may be disposed inside the vehicle AM, and may thus provide various information to a driver US.

The display device DD may display an image IM on a display surface IS parallel to each of a first direction DR1 and a second direction DR2. The display surface IS on which the image IM is displayed may correspond to a front surface of the display device DD. The image IM may include a still image as well as a dynamic image. The normal direction of the display surface IS, which is the thickness direction of the display device DD, is indicated by a third direction DR3. A front surface (or upper surface) and a rear surface (lower surface) of each of layers or units, to be described hereinafter, are distinguished on the basis of the third direction DR3.

In the description, the first direction DR1 may be referred to as the upward and downward directions, the second direction DR2 may be referred to as the left and right directions, and the third direction DR3 may be referred to as the thickness direction.

The display surface IS of the display device DD may be divided into a display region DA and a non-display region NDA. The display region DA may be a region where the image IM is displayed. A user views the image IM through the display region DA. In the description, the display region DA is illustrated in rectangular shape. However, this is illustrated as an example, the display region DA may have various shapes, and the shape is not limited to any one embodiment.

The non-display region NDA may be adjacent to the display region DA. The non-display region NDA may have a selected color. The non-display region NDA may surround the display region DA. Accordingly, the shape of the display region DA may be substantially defined by the non-display region NDA. However, this is illustrated as an example, and the non-display region NDA may also be disposed adjacent to only a single side of the display region DA, and may also be omitted. The display device DD, according to an embodiment, may include various embodiments, and is not limited to any one embodiment.

The display region DA may include a first display region DA1 and a second display region DA2. The first display region DA1 may be disposed at a position facing the driver's seat, and may provide a first image IM1 that is necessary for driving to the driver US who is driving. The second display region DA2 may be disposed at a position facing a passenger seat, and may provide a second image IM2. For example, the first image IM1 may display information on speed, vehicle condition, vehicle internal manipulation, etc., and the second image IM2 may display not only information necessary for driving such as navigation information, but also various information unrelated to the driving.

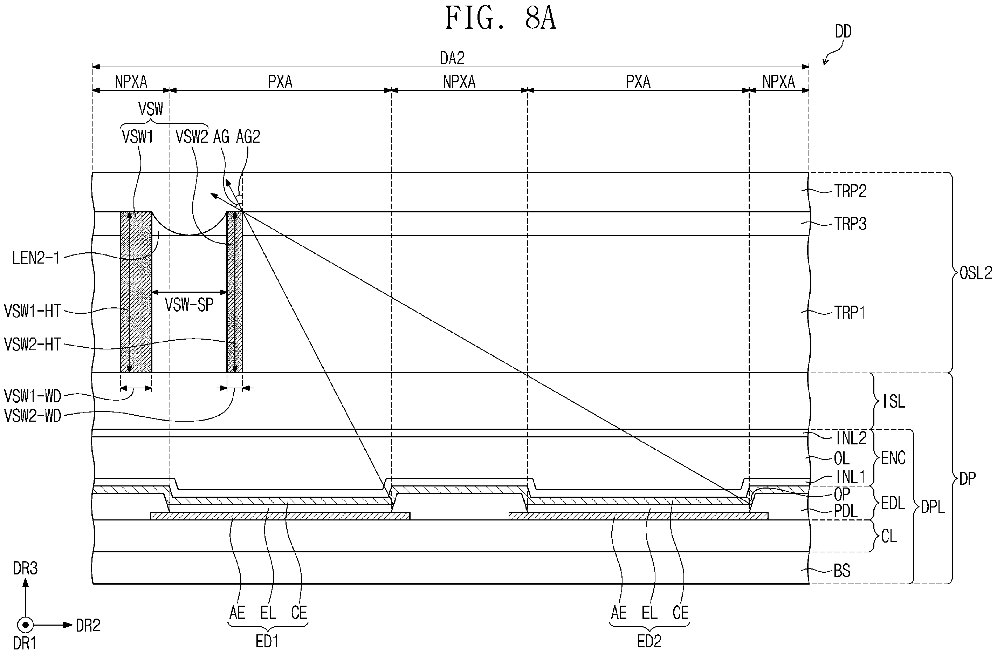

The display device DD may operate in a first mode or a second mode. The first display region DA1 may have a limited viewing angle AG1 in the first direction DR1, such as upward and downward directions, in both the first mode and the second mode. The second display region DA2 may be operated in the first mode that is a general mode where a screen is displayed at a first viewing angle AG (see FIG. 8A) in the second direction DR2, such as left and right directions, and in the second mode that is a viewing angle control mode where the screen is displayed at a second viewing angle AG2 (see FIG. 8A) smaller than the first viewing angle.

Referring to FIG. 2A, in the first mode, both the first image IM1 of the first display region DA1 and the second image IM2 of the second display region DA2 may be viewed to the driver US. The first mode may operate during a stop. In the first mode, the driver US may also watch information unnecessary for the driving.

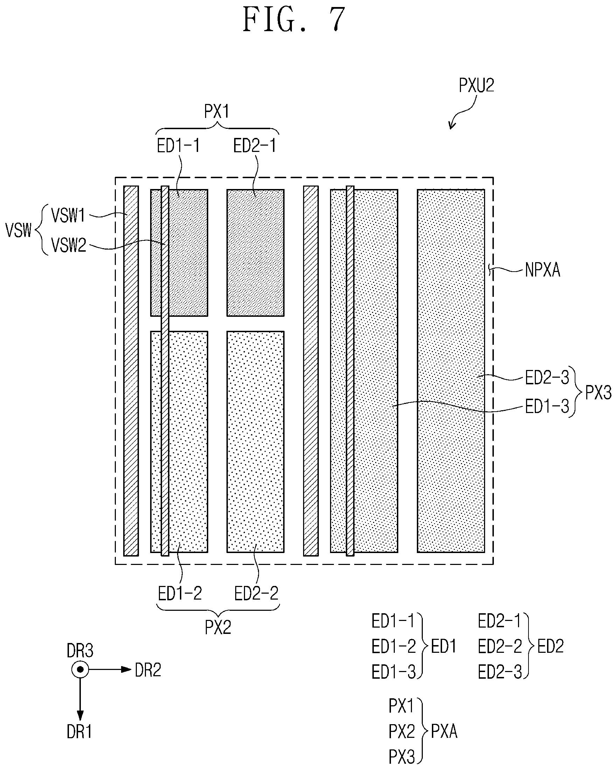

Referring to FIG. 2B, in the second mode, the first image IM1 of the first display region DA1 may be viewed to the driver US, and the second image IM2 of the second display region DA2 may not be viewed to the driver US. The second mode may operate in case of driving. The driver US may watch only the information necessary for the driving, and may not watch the information unnecessary for the driving due to the limited viewing angle. FIG. 2B illustrates that the entire second display region DA2 is not viewed to the driver US, but embodiments are not limited thereto, and a partial region of the second display region DA2 may be viewed, and the other partial region may not be viewed. For example, it may be possible to watch only the information necessary for the driving (for example, the navigation information) in the partial region of the second display region DA2 disposed adjacent to the first display region DA1, and it may not be possible to watch the information unnecessary for the driving in the other partial region, disposed apart from the first display region DA1. By controlling a region in which each of a first-type light-emitting element ED1 (see FIG. 7) and a second-type light-emitting element ED2 (see FIG. 7), to be described later, operates, it may be possible to control the region of the second display region DA2 visible to the driver US in the second mode.

The display device DD may operate selectively in either the first mode or the second mode. Transition between the first mode and the second mode may be set by a user, or take place during driving or at a stop, or in case that a particular application runs.

Referring to FIG. 2C, both in the first mode and the second mode, the first display region DA1 (see FIG. 2A) may have the viewing angle AG1 limited in the first direction DR1 (e.g., upward and downward directions). For example, light IM1-L, provided from the first display region DA1 (see FIG. 2A), may be invisible at an angle exceeding the viewing angle AG1. A path of the light IM1-L, provided from the first display region DA1, may be limited to the first direction DR1 (e.g., upward and downward directions), so that the light IM1-L may not reach a windshield WSD of the vehicle AM. Therefore, in case that the light IM1-L, provided from the first display region DA1 (see FIG. 2A), reaches the windshield WSD of the vehicle AM, the reflected light may be invisible to the driver US, so that the safety may be ensured or secured.

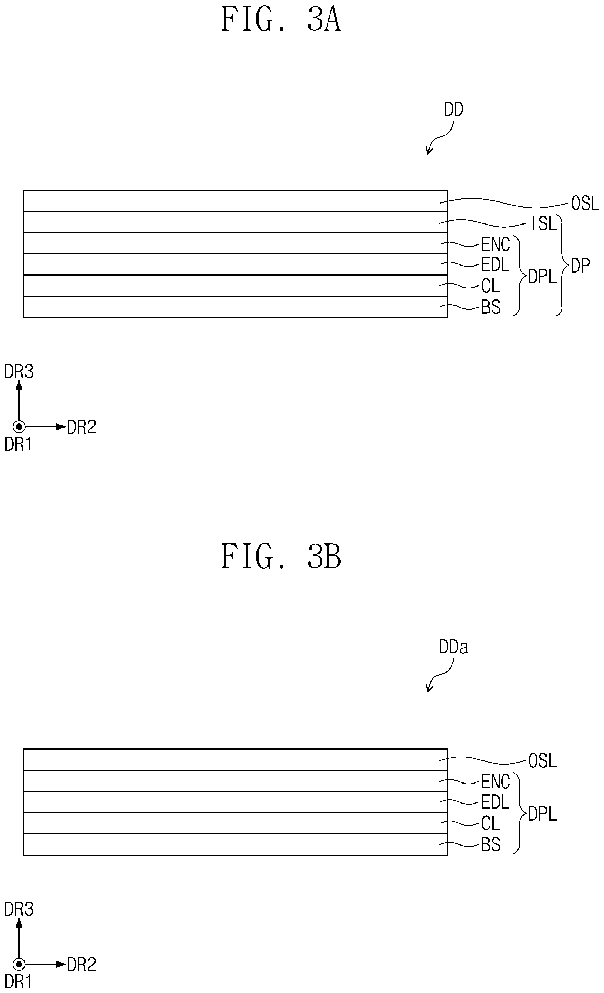

FIGS. 3A and 3B are schematic cross-sectional views each illustrating a display device DD according to an embodiment.

Referring to FIG. 3A, the display device DD may include a display panel DP and a light-path control layer OSL. A protection film, a window, or a functional coating layer, which provides a front surface of the display device DD, may further be disposed on the light-path control layer OSL.

The display panel DP may include a display layer DPL and a sensor layer ISL.

The display layer DPL may include a base layer BS, a circuit layer CL, a light-emitting element layer EDL, and an encapsulation layer ENC. The display layer DPL may be a component that substantially generates an image. The display layer DPL may be an emission-type display layer, and for example, the display layer DPL may be an organic light-emitting display layer, an inorganic light-emitting display layer, an organic-inorganic light-emitting display layer, a quantum-dot display layer, a micro-LED display layer, or a nano-LED display layer.

The sensor layer ISL may detect an external input applied from the outside. The external input may be a user's input. The user's input may include various types of external inputs such as a part of the user's body, light, heat, a pen, or pressure. The sensor layer ISL may be referred to as a sensor, an input-sensing layer, or an input-sensing panel. The sensor layer ISL may be formed by a continuous process with the display layer DPL to be disposed (e.g., directly disposed) on the display layer DPL. However, embodiments are not limited thereto. For example, the sensor layer ISL may also be bonded to the display layer DPL by an adhesive layer.

The light-path control layer OSL may control a path of light provided from the display layer DPL. The light-path control layer OSL may include a structure for controlling the path of the light. The light-path control layer OSL may be disposed on the sensor layer ISL. The light-path control layer OSL may be formed by a continuous process with the display layer DPL and the sensor layer ISL to be disposed (e.g., directly disposed) on the sensor layer ISL. However, embodiments are not limited thereto. For example, the light-path control layer OSL may also be bonded to the sensor layer ISL through an adhesive layer.

Referring to FIG. 3B, a display device DDa according to an embodiment may include a display layer DPL and a light-path control layer OSL. Compared to FIG. 3A, the display device DDa in FIG. 3B may not include a sensor layer ISL (see FIG. 3A). The light-path control layer OSL may be formed by a continuous process with the display layer DPL to be disposed (e.g., directly disposed) on the display layer DPL. However, embodiments are not limited thereto.

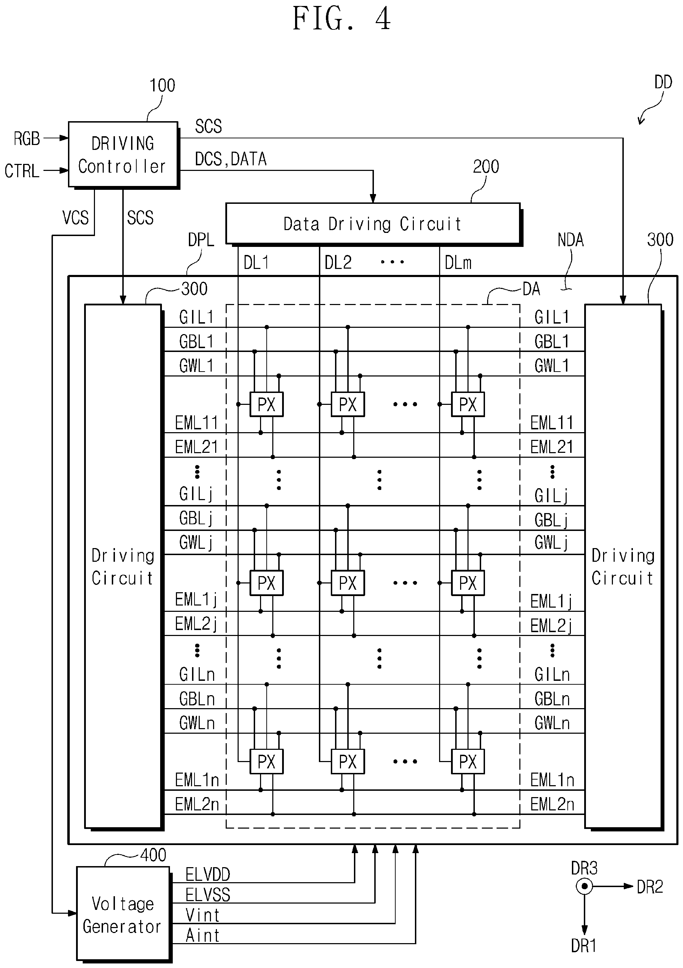

FIG. 4 is a block diagram of a display device DD according to an embodiment.

Referring to FIG. 4, the display device DD may further include a driving controller 100 for driving a display layer DPL, and a panel driver. As an example, the panel driver may include a data driving circuit 200 (or data driver), driving circuits 300, and a voltage generator 400.

The display layer DPL may include a display region DA and a non-display region NDA. The display layer DPL may include pixels PX disposed in the display region DA. Each of the pixels PX may include at least one light-emitting element and a pixel driving circuit that controls emission of the light-emitting element ED. The pixel driving circuit may include at least one transistor and at least one capacitor.

The display layer DPL may further include initialization scan lines GIL1 to GILn, write scan lines GWL1 to GWLn, black scan lines GBL1 to GBLn, first emission control lines EML11 to EML1n, second emission control lines EML21 to EML2n, and data lines DL1 to DLm. According to an embodiment, the display layer DPL may further include other third emission control lines.

The driving controller 100 may receive an image signal RGB and a control signal CTRL. The driving controller 100 may generate an image data signal DATA converted from the image signal RGB such that the data format thereof is in accordance with interface specifications of the data driving circuit 200. The driving controller 100 may output a first control signal SCS, a second control signal DCS, and a third control signal VCS.

The data driving circuit 200 may receive a second control signal DCS and the image data signal DATA from the driving controller 100. The data driving circuit 200 may convert the image data signal DATA into data signals, and may output the data signals through the data lines DL1 to DLm. The data signals may be analog voltages corresponding to a grayscale value of the image data signal DATA. The data lines DL1 to DLm may be arranged along a second direction DR2, and the data lines DL1 to DLm may each extend along a first direction DR1.

The driving circuit 300 may be disposed in the non-display region NDA of the display layer DPL, but embodiments are not limited thereto. For example, at least a portion of the driving circuit 300 may also be disposed in the display region DA. The driving circuits 300 may include the transistors formed by the same process as that of the pixel driving circuit.

The driving circuit 300 may receive the first control signal SCS, and output a scan signal or an emission control signal through the initialization scan lines GIL1 to GILn, the write scan lines GWL1 to GWLn, the black scan lines GBL1 to GBLn, the first emission control lines EML11 to EML1n, and the second emission control lines EML21 to EML2n.

The driving circuit 300 may be provided in plurality. For example, the driving circuits 300 may be spaced apart from each other with the display region DA therebetween. The initialization scan lines GIL1 to GILn, the write scan lines GWL1 to GWLn, the black scan lines GBL1 to GBLn, the first emission control lines EML11 to EML1n, and the second emission control lines EML21 to EML2n may each be electrically connected to the driving circuits 300 to receive signals from the driving circuits 300. For example, one initialization scan line GIL1, one write scan line GWL1, one black scan line GBL1, one first emission control line EML11, and one second emission control line EML21 may each receive the same signals from two driving circuits 300. However, this is only an example, and one of the two driving circuits 300, illustrated in FIG. 4, may also be omitted.

The driving circuits 300 may each include a scan driving circuit connected to the initialization scan lines GIL1 to GILn, the write scan lines GWL1 to GWLn, and the black scan lines GBL1 to GBLn, and an emission-control driving circuit connected to the first emission control lines EML11 to EML1n and the second emission control lines EML21 to EML2n. According to an embodiment, the scan driving circuit and the emission-control driving circuit may be spaced apart from each other with the display region DA therebetween.

The initialization scan lines GIL1 to GILn, the write scan lines GWL1 to GWLn, the black scan lines GBL1 to GBLn, the first emission control lines EML11 to EML1n, and the second emission control lines EML21 to EML2n may each extend in the second direction DR2, and the initialization scan lines GIL1 to GILn, the write scan lines GWL1 to GWLn, the black scan lines GBL1 to GBLn, the first emission control lines EML11 to EML1n, and the second emission control lines EML21 to EML2n may be spaced apart from each other in the first direction DR1.

The pixels PX may each be electrically connected to three scan lines, two emission control lines, and one data line. For example, as illustrated in FIG. 4, pixels PX on a first row may be connected to the scan lines GIL1, GWL1, and GBL1, and the first and second emission control lines EML11 and EML21. Pixels PX on a first column may be connected to the data line DL1. For example, pixels PX on a j-th row may be connected to the scan lines GILj, GWLj, and GBLj and the first and second emission control lines EML1j and EML2j. Here, j is a natural number greater than zero.

The voltage generator 400 may generate voltages necessary for operation of a display panel DP. In an embodiment, the voltage generator 400 may generate a first driving voltage ELVDD, a second driving voltage ELVSS, a first initialization voltage Vint, and a second initialization voltage Aint.

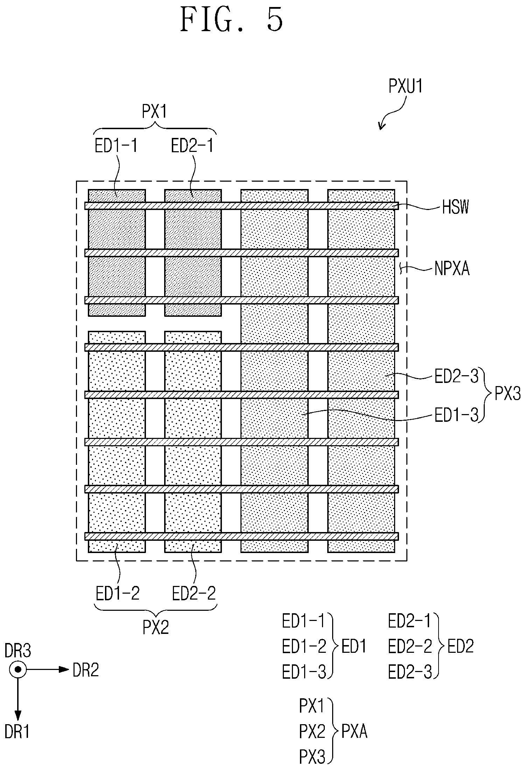

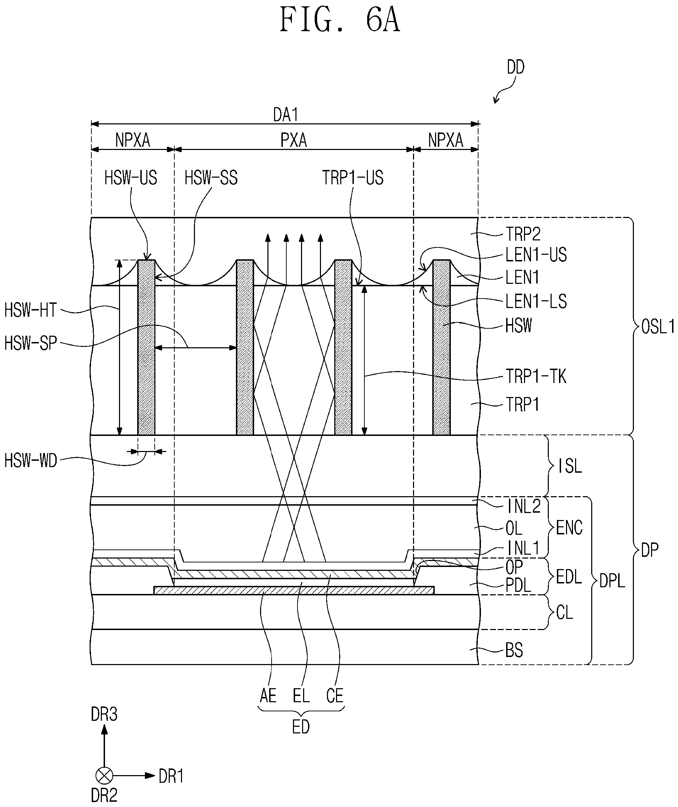

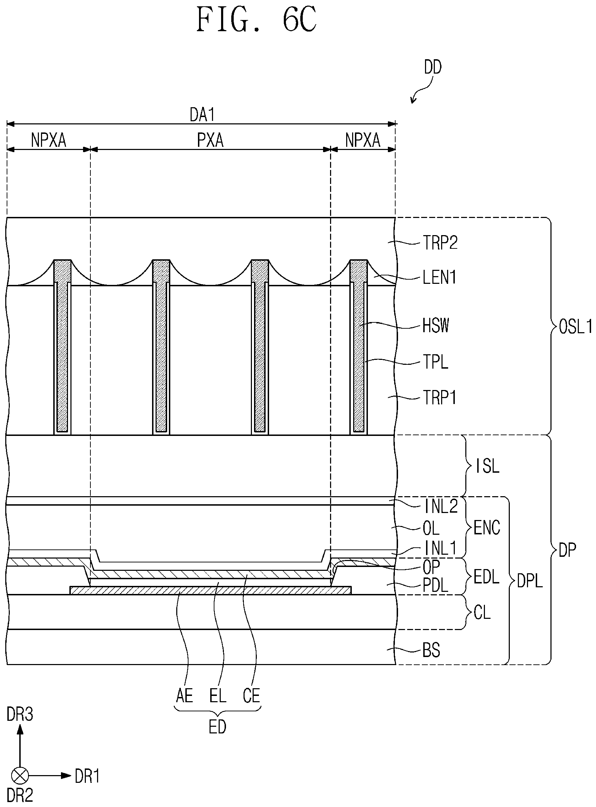

FIG. 5 is an enlarged schematic plan view of the first display region DA1 (see FIG. 1) according to an embodiment. FIGS. 6A and 6C are schematic cross-sectional views each illustrating a portion of the first display region DA1 according to an embodiment.

FIG. 5 illustrates a schematic plan view of the first display region DA1 (see FIG. 1), according to an embodiment, where light-emitting elements ED1 and ED2 included in the display panel DP (see FIG. 3A) and horizontal walls (e.g., horizontal partition walls) HSW, included in a light-path control layer OSL1 (see FIG. 6A), are viewed from a third direction DR3. The light-path control layer OSL1 of the first display region DA1 (see FIG. 1) may be referred to as a first light-path control layer.

Referring to FIG. 5, pixels PX1, PX2, and PX3 may be disposed in the first display region DA1 (see FIG. 1) of the display panel DP (see FIG. 3A). The pixels PX1, PX2, and PX3 may include a first color pixel PX1, a second color pixel PX2, and a third color pixel PX3. The first color pixel PX1 may provide first color light, for example, red color light. The second color pixel PX2 may provide second color light, for example, green color light. The third color pixel PX3 may provide third color light, for example, blue color light.

The second color pixel PX2 may be disposed apart from the first color pixel PX1 in a first direction DR1. The third color pixel PX3 may be disposed apart from the first color pixel PX1 and the second color pixel PX2 in a second direction DR2. However, the arrangement of the first to third color pixels PX1, PX2, and PX3 is not limited thereto.

FIG. 5 illustrates that a single pixel unit PXU1 includes three pixels PX1, PX2, and PX3. However, the single pixel unit PXU1 may also include two pixels, or include four or more pixels. For example, FIG. 5 illustrates that the area of the third color pixel PX3 is the largest, and the area of the first color pixel PX1 is the smallest, but embodiments are not limited thereto, and the areas of the first to third color pixels PX1, PX2, and PX3 may vary. For example, FIG. 5 illustrates that the first to third color pixels PX1, PX2, and PX3 are rectangles on a plane (or in plan view), but the shape of the first to third color pixels PX1, PX2, and PX3 on a plane (or in plan view) is not limited thereto.

The pixel unit PXU1 may include a first-type light-emitting element ED1 and a second-type light-emitting element ED2. The first-type light-emitting element ED1 and the second-type light-emitting element ED2 may be alternately disposed along the second direction DR2. The first-type light-emitting element ED1 and the second-type light-emitting element ED2 may operate differently from each other. For example, both of the first-type light-emitting element ED1 and the second-type light-emitting element ED2 may operate, or only one of the two may operate. For example, in a first mode, the first-type light-emitting element ED1 may not operate, and only the second-type light-emitting element ED2 may operate, and in a second mode, only the first-type light-emitting element ED1 may operate, and the second-type light-emitting element ED2 may not operate.

The first-type light-emitting element ED1 may include a (1-1)-th type light-emitting element ED1-1 disposed on the first color pixel PX1, a (1-2)-th type light-emitting element ED1-2 disposed on the second color pixel PX2, and a (1-3)-th type light-emitting element ED1-3 disposed on the third color pixel PX3. The second-type light-emitting element ED2 may include a (2-1)-th type light-emitting element ED2-1 disposed on the first color pixel PX1, a (2-2)-th type light-emitting element ED2-2 disposed on the second color pixel PX2, and a (2-3)-th type light-emitting element ED2-3 disposed on the third color pixel PX3.

The (2-1)-th type light-emitting element ED2-1 may be disposed apart from the (1-1)-th type light-emitting element ED1-1 in the second direction DR2. The (2-2)-th type light-emitting element ED2-2 may be disposed apart from the (1-2)-th type light-emitting element ED1-2 in the second direction DR2. The (2-3)-th type light-emitting element ED2-3 may be disposed apart from the (1-3)-th type light-emitting element ED1-3 in the second direction DR2. The (1-2)-th type light-emitting element ED1-2 may be disposed apart from the (1-1)-th type light-emitting element ED1-1 in the first direction DR1. The (2-2)-th type light-emitting element ED2-2 may be disposed apart from the (2-1)-th type light-emitting element ED2-1 in the first direction DR1.

The horizontal walls HSW may be arranged along the first direction DR1. The horizontal walls HSW may each extend along the second direction DR2.

Referring to FIG. 6A, the display device DD in the first display region DA1 may include a display panel DP and a first light-path control layer OSL1. The display panel DP may include a display layer DPL and a sensor layer ISL. As previously described, the sensor layer ISL may be omitted.

The display layer DPL may include a base layer BS, a circuit layer CL, a light-emitting element layer EDL, and an encapsulation layer ENC.

The base layer BS may be a member that provides a base surface on which the circuit layer CL is disposed. The base layer BS may include a synthetic resin layer. The synthetic resin layer may be a polyimide-based resin layer, and the material is not limited. For example, the base layer BS may include a glass substrate, a metal substrate, an organic/inorganic composite material substrate, or the like.

The display layer DPL may further include an inorganic layer on an upper surface of the base layer BS. The inorganic layer may include at least one of aluminum oxide, titanium oxide, silicon oxide, silicon nitride, silicon oxynitride, zirconium oxide, or hafnium oxide. The inorganic layer may be formed in multiple layers. The multi-layer inorganic layers may include a barrier layer and/or buffer layer.

The circuit layer CL may be disposed on the base layer BS. A semiconductor pattern may be disposed on the circuit layer CL. The semiconductor pattern may include polysilicon. However, embodiments are not limited thereto, and the semiconductor pattern may include amorphous silicon, low temperature polycrystalline silicon, or an oxide semiconductor. The circuit layer CL may further include insulation layers. The insulation layers may cover the semiconductor pattern. Some of the insulation layers may be inorganic layers and others may be organic layers. In case that the insulation layer is an inorganic layer, the insulation layer may include at least one of, for example, aluminum oxide, titanium oxide, silicon oxide, silicon nitride, silicon oxynitride, zirconium oxide, or hafnium oxide.

The light-emitting element layer EDL may be disposed on the circuit layer CL. The light-emitting element layer EDL may include a light-emitting element ED. For example, the light-emitting element layer EDL may include an organic light-emitting material, an inorganic light-emitting material, an organic-inorganic light-emitting material, quantum dots, quantum rods, a micro-LED, or a nano-LED. Hereinafter, it is described, as an example, that the light-emitting element ED is the organic light-emitting element, but embodiments are not limited thereto.

The light-emitting element ED in FIG. 6A may correspond to all of the light-emitting elements ED1 and ED2 in FIG. 5.

The light-emitting element ED may include a first electrode AE, a light-emitting layer EL, and a second electrode CE.

The first electrode AE may be disposed on the circuit layer CL. The first electrode AE may be electrically connected to the semiconductor pattern of the circuit layer CL. The first electrode AE may have conductivity. The first electrode AE may be formed of a metal material, a metal alloy, or a conductive compound. The first electrode AE may be an anode or a cathode. However, embodiments are not limited thereto. For example, the first electrode AE may be a pixel electrode. The first electrode AE may be a transmissive electrode, a transflective electrode, or a reflective electrode. The first electrode AE may include at least one selected from Ag, Mg, Cu, Al, Pt, Pd, Au, Ni, Nd, Ir, Cr, Li, Ca, LiF, Mo, Ti, W, In, Sn, and Zn, a compound of at least two selected therefrom, a mixture of at least two selected therefrom, or an oxide thereof.

In case that the first electrode AE is the transmissive electrode, the first electrode AE may include a transparent metal oxide, such as indium tin oxide (ITO), indium zinc oxide (IZO), zinc oxide (ZnO), and indium tin zinc oxide (ITZO). In case that the first electrode AE is the transflective electrode or reflective electrode, the first electrode AE may include Ag, Mg, Cu, Al, Pt, Pd, Au, Ni, Nd, Ir, Cr, Li, Ca, LiF/Ca (e.g., a stacked structure of LiF and Ca), LiF/AI (e.g., a stacked structure of LiF and Al), Mo, Ti, W, or a compound thereof or mixture thereof (for example, a mixture of Ag and Mg). In another example, the first electrode AE may have a multi-layer structure including a reflective film or transflective film formed of the above-mentioned materials, and a transparent conductive film formed of indium tin oxide (ITO), indium zinc oxide (IZO), zinc oxide (ZnO), indium tin zinc oxide (ITZO), etc. For example, the first electrode AE may have a three-layer structure of ITO/Ag/ITO, but embodiments are not limited thereto. For example, embodiments are not limited thereto, and the first electrode AE may include the above-described metal materials, a combination of at least two metal materials selected from the above-described metal materials, an oxide of the above-described metal materials, or the like.

The light-emitting element layer EDL may include a pixel-defining film PDL. The pixel-defining film PDL may be disposed on the circuit layer CL, and may cover a portion of the first electrode AE. The pixel-defining film PDL may have an opening OP defined (or formed) in the pixel-defining film PDL. The opening OP of the pixel-defining film PDL may expose at least a portion of the first electrode AE.

The display region DA (see FIG. 1) may include a light-emitting region PXA and a non-light-emitting region NPXA adjacent to the light-emitting region PXA. The non-light-emitting region NPXA may surround the light-emitting region PXA. In an embodiment, the light-emitting region PXA may be defined to correspond to a partial region of the first electrode AE exposed by the opening OP.

The light-emitting layer EL may be disposed on the first electrode AE. The light-emitting layer EL may be disposed in a region corresponding to the opening OP. For example, the light-emitting layer EL may be formed separately for each pixel PX. In case that the light-emitting layer EL is formed separately for each pixel PX, the light-emitting layers EL may each emit light of at least one color of red color, green color, or blue color. However, embodiments are not limited thereto, and the light-emitting layer EL may be connected to the pixels PX to be provided in common. For example, the light-emitting layer EL may provide the blue color light, or may also provide white color light.

The second electrode CE may be disposed on the light-emitting layer EL. The second electrode CE may have an integrated shape to be disposed on pixels PX in common. The second electrode CE may be a cathode or an anode, but embodiments are not limited thereto. For example, in case that the first electrode AE is the anode, the second electrode CE may be the cathode, and in case that the first electrode AE is the cathode, the second electrode CE may be the anode. The material of the second electrode CE may include the materials that are previously described for the first electrode AE.

For example, a hole control layer may be disposed between the first electrode AE and the light-emitting layer EL. The hole control layer may be disposed in the light-emitting region PXA and the non-light-emitting region NPXA in common. The hole control layer may include a hole transport layer, and may further include a hole injection layer. An electron control layer may be disposed between the light-emitting layer EL and the second electrode CE. The electron control layer may include an electron transport layer, and may further include an electron injection layer. The hole control layer and the electron control layer may be provided to the pixels PX in common using an open mask.

The encapsulation layer ENC may be disposed on the light-emitting element layer EDL. The encapsulation layer ENC may include an inorganic layer INL1, an organic layer OL, and an inorganic layer INL2 that are stacked in sequence, but the layers constituting the encapsulation layer ENC are not limited thereto.

The inorganic layers INL1 and INL2 may protect the light-emitting element layer EDL from moisture and oxygen, and the organic layer OL may protect the light-emitting element layer EDL from foreign substances such as dust particles. The inorganic layers INL1 and INL2 may include a silicon nitride layer, a silicon oxynitride layer, a silicon oxide layer, a titanium oxide layer, an aluminum oxide layer, or the like. The organic layer OL may include an acrylate-based organic material, and is not limited thereto.

The sensor layer ISL may include at least one conductive layer and at least one insulation layer.

The conductive layer may have a single-layer or multi-layer structure. The single-layer conductive layer may include a metal layer or a transparent conductive layer. The metal layer may include molybdenum, silver, titanium, copper, aluminum, or an alloy thereof. The transparent conductive layer may include a transparent conductive oxide such as indium tin oxide (ITO), indium zinc oxide (IZO), zinc oxide (ZnO), indium zinc tin oxide (IZTO), or the like. For example, the transparent conductive layer may include a conductive polymer such as PEDOT, metal nanowires, graphene, etc. The multi-layer conductive layer may include metal layers. The metal layers may have a three-layer structure of, for example, titanium/aluminum/titanium. The multi-layer conductive layer may include at least one metal layer and at least one transparent conductive layer.

The insulation layer may include an inorganic film. The inorganic film may include at least one of aluminum oxide, titanium oxide, silicon oxide, silicon nitride, silicon oxynitride, zirconium oxide, or hafnium oxide. The insulation layer may include an organic film. The organic film may include at least any one of an acrylate-based resin, a methacrylate-based resin, polyisoprene, a vinyl-based resin, an epoxy-based resin, a urethane-based resin, a cellulose-based resin, a siloxane-based resin, a polyimide-based resin, a polyamide-based resin, or a perylene-based resin.

The first light-path control layer OSL1 may include horizontal walls HSW, a first transmission part TRP1 disposed between the horizontal walls HSW, a light-collecting part LEN1 disposed on the first transmission part TRP1, and a second transmission part TRP2 disposed on the light-collecting part LEN1. The first light-path control layer OSL1 may be disposed on the display panel DP of the first display region DA1.

In the first display region DA1, the first-type light-emitting element ED1 and the second-type light-emitting element ED2 may overlap the horizontal walls HSW on a plane (or in plan view). The first-type light-emitting element ED1 and the second-type light-emitting element ED2 in FIG. 5 may correspond to the light-emitting element ED in FIG. 6A. As the light-emitting element ED overlaps the horizontal walls HSW, as illustrated in FIG. 6A, the viewing angle of light emitted from the light-emitting element ED may be limited in the first direction DR1. For example, the image IM1 (see FIG. 1) of the first display region DA1 (see FIG. 1) may be invisible at the angle exceeding the viewing angle in the first direction DR1 on the basis of the third direction DR3 (0°). Therefore, as previously described with reference to FIG. 2C, the light IM1-L (see FIG. 2C), emitted from the first display region DA1 (see FIG. 1), may be prevented from being reflected on the windshield WSD (see FIG. 2C) of the vehicle AM (see FIG. 2C) and thus from being visible to the driver US (see FIG. 2C).

The horizontal walls HSW may include a light-absorbing material or a light-blocking material. Light incident to the horizontal walls HSW may be absorbed by the horizontal walls HSW. A part of the light incident to the horizontal walls HSW may not be absorbed and may be reflected.

A height HSW-HT, a width HSW_WD, and a distance HSW-SP of the horizontal walls may each vary according to the required pixel per inch (ppi) or required viewing angle.

The first transmission part TRP1 may be disposed between the horizontal walls HSW. A thickness TRP1-TK of the first transmission part TRP1 may be smaller than the height HSW-HT of the horizontal walls HSW. The thickness TRP1-TK of the first transmission part TRP1 may refer to the length of the first transmission part TRP1 in the third direction DR3. The heights HSW-HT of the horizontal walls HSW may refer to the lengths of the horizontal walls HSW in the third direction DR3. A lower surface of the first transmission part TRP1 may be disposed on the same flat surface as that on which lower surfaces of the horizontal walls HSW are disposed. An upper surface of the first transmission part TRP1 may be disposed on a flat surface different from that on which upper surfaces HSW-US of the horizontal walls HSW are disposed. The horizontal walls HSW may be disposed to protrude in the third direction DR3 with respect to the upper surface of the first transmission part TRP1. Portions of side surfaces HSW-SS of the horizontal walls HSW, more protruding than the upper surface TRP1-US of the first transmission part TRP1 in the third direction DR3, may not be covered by the first transmission part TRP1, and may be exposed. The upper surfaces HSW-US of the horizontal walls HSW may not be covered by the first transmission part TRP1, and may be exposed.

The first transmission part TRP1 may include a transparent organic material. The first transmission part TRP1 may be transparent in a visible light region. Light provided from the display panel DP may pass through the first transmission part TRP1.

The first transmission part TRP1 may have a low refractive index. For example, the refractive index of the first transmission part TRP1 may be in a range of about 1.4 to about 1.5.

The light-collecting part LEN1 may be disposed on the first transmission part TRP1. The light-collecting part LEN1 may cover the upper surface TRP1-US of the first transmission part TRP1. A lower surface LEN1-LS of the light-collecting part LEN1 may correspond to the upper surface TRP1-US of the first transmission part TRP1. An upper surface LEN1-US of the light-collecting part LEN1 may have a curvature. The upper surface LEN1-US of the light-collecting part LEN1 may be concave (or recessed) in a direction toward the first transmission part TRP1. For example, the upper surface LEN1-US of the light-collecting part LEN1 may be concave (or recessed) in the third direction DR3.

Since the upper surface LEN1-US of the light-collecting part LEN1 has the concave shape, light incident from the light-collecting part LEN1 to the second transmission part TRP2 may be refracted in the third direction DR3 at a boundary surface between the light-collecting part LEN1 and the second transmission part TRP2 which has a high refractive index, to be described later, thereby having a light-collecting effect. Accordingly, the viewing angle limitation characteristics and the front light-emitting efficiency of the first display region DA1 may be improved. For example, the front may mean a direction facing the user US (see FIG. 1). For example, the front light-emitting efficiency may mean the light-emitting efficiency in the third direction DR3.

The light-collecting part LEN1 may be disposed between the horizontal walls HSW. The light-collecting part LEN1 may be disposed (e.g., directly disposed) by covering the portions of the side surfaces HSW-SS of the horizontal walls HSW more protruding than the first transmission part TRP1 and thus not covered by the first transmission part TRP1 and exposed. FIG.6A illustrates that the light-collecting part LEN1 is not disposed on the upper surfaces HSW-US of the horizontal walls HSW, but embodiments are not limited thereto, and the light-collecting part LEN1 may also be disposed by covering the upper surfaces HSW-US of the horizontal walls HSW.

The light-collecting part LEN1 may include a transparent organic material. The light-collecting part LEN1 may be transparent in a visible light region. Light provided from the display panel DP may pass through the light-collecting part LEN1.

The light-collecting part LEN1 may have a low refractive index. For example, the refractive index of the light-collecting part LEN1 may be in a range of about 1.4 to about 1.5. The light-collecting part LEN1 and the first transmission part TRP1 may have a similar refractive index or a same refractive index. Since the light-collecting part LEN1 has the similar refractive index with the first transmission part TRP1, light incident from the first transmission part TRP1 to the light-collecting part LEN1 may proceed without refraction at a boundary surface between the first transmission part TRP1 and the light-collecting part LEN1. The light-collecting part LEN1 disposed in the first display region DA1 may also be referred to as a first light-collecting part.

The second transmission part TRP2 may be disposed on the light-collecting part LEN1. The second transmission part TRP2 may be disposed to fill grooves defined by the upper surface LEN1-US of the light-collecting part LEN1 including curvatures.

The second transmission part TRP2 may include a transparent organic material. The second transmission part TRP2 may be transparent in a visible light region. Light provided from the display panel DP may pass through the second transmission part TRP2.

The second transmission part TRP2 may have a high refractive index. The refractive index of the second transmission part TRP2 may be greater than the refractive index of the first transmission part TRP1 and the refractive index of the light-collecting part LEN1. For example, the refractive index of the second transmission part TRP2 may be in a range of about 1.55 to about 1.8.

Since the second transmission part TRP2 has a refractive index greater than that of the light-collecting part LEN1, light incident from the light-collecting part LEN1 to the second transmission part TRP2 may be refracted at the boundary surface between the light-collecting part LEN1 and the second transmission part TRP2, thereby having a light-collecting effect in the third direction DR3. Accordingly, the viewing angle limitation characteristics and the front light-emitting efficiency of the first display region DA1 may be improved.

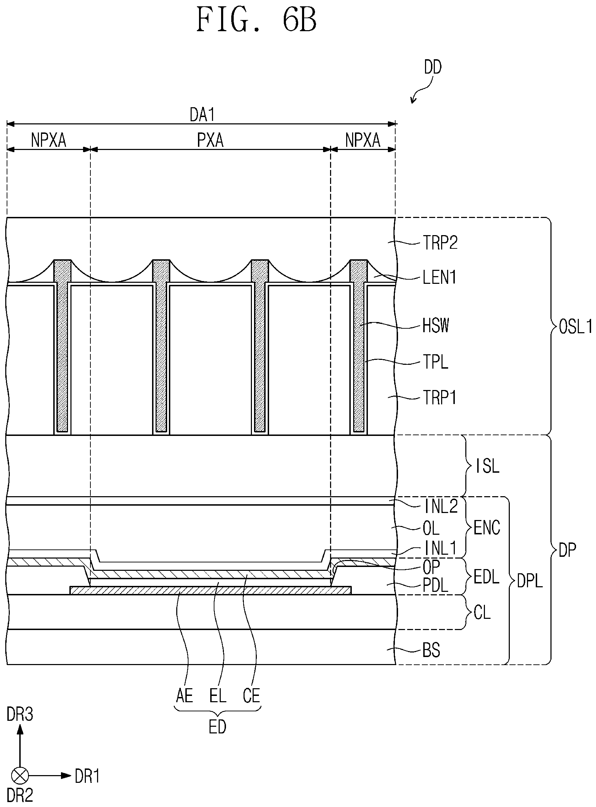

The contents previously described with reference to FIG. 6A may also be applied to FIGS. 6B and 6C below.

Referring to FIG. 6B, a first light-path control layer OSL1 according to an embodiment may further include a transparent protection film TPL. The transparent protection film TPL may be disposed between horizontal walls HSW and a first transmission part TRP1, and between a light-collecting part LEN1 and the first transmission part TRP1. For example, the transparent protection film TPL may be disposed (e.g., directly disposed) by covering an upper surface and a side surface of the first transmission part TRP1. The transparent protection film TPL may also be disposed between a display panel DP and the horizontal walls HSW.

The transparent protection film TPL may include a transparent material. The transparent protection film TPL may include an inorganic material. For example, the transparent protection film TPL may include silicon nitride (SiNₓ), silicon oxide (SiO_{y}), and/or a transparent conductive oxide.

Referring to FIG. 6C, a first light-path control layer OSL1 according to an embodiment may further include a transparent protection film TPL. The transparent protection film TPL, unlike in FIG. 6B, may be disposed between horizontal walls HSW and a first transmission part TRP1, and between a display panel DP and the horizontal walls HSW, and may not be disposed between a light-collecting part LEN1 and the first transmission part TRP1. The transparent protection film TPL may extend from an area between the first transmission part TRP1 and the horizontal walls HSW to an area between the light-collecting part LEN1 and the horizontal walls HSW. Therefore, portions of the light-collecting part LEN1 may be disposed (e.g., directly disposed) in contact with side surfaces of the horizontal walls HSW, and portions of the light-collecting part LEN1 may be disposed on the side surfaces of the horizontal walls HSW with the transparent protection film TPL therebetween.

FIG. 7 is an enlarged schematic plan view of the second display region DA2 (see FIG. 1) according to an embodiment. FIGS. 8A to 8D are schematic cross-sectional views each illustrating a portion of the second display region DA2 according to an embodiment.

FIG. 7 illustrates a schematic plan view of the second display region DA2 (see FIG. 1), according to an embodiment, where light-emitting elements ED1 and ED2 included in the display panel DP (see FIG. 3A) and vertical walls (e.g., vertical partition walls) VSW included in a light-path control layer OSL2 (see FIG. 8A) are viewed from a third direction DR3. The light-path control layer OSL2 of the second display region DA2 (see FIG. 1) may be referred to as a second light-path control layer.

A pixel unit PXU2 of the second display region DA2 may include first to third color pixels PX1, PX2, and PX3. The description on the first to third color pixels PX1, PX2, and PX3 of the first display region DA1 (see FIG. 5), previously described with reference to FIG. 5, may be applied to the first to third color pixels PX1, PX2, and PX3.

The pixel unit PXU2 may include a first-type light-emitting element ED1 and a second-type light-emitting element ED2, and the description with reference to FIG. 5 may be applied to the first-type light-emitting element ED1 and the second-type light-emitting element ED2.

The vertical walls VSW may be arranged along a second direction DR2. The vertical walls VSW may extend along a first direction DR1.

The display device DD of the second display region DA2 may include a display panel DP and a second light-path control layer OSL2. The contents described with reference to FIG. 6A may be applied to the display panel DP.

Referring to FIGS. 7 and 8A, the second light-path control layer OSL2 may include the vertical walls VSW, a first transmission part TRP1 disposed between the vertical walls VSW, a light-collecting part LEN2-1 disposed on the first transmission part TRP1, and a second transmission part TRP2 disposed on the light-collecting part LEN2-1. The second light-path control layer OSL2 may further include a third transmission part TRP3 disposed on the first transmission part TRP1. The second light-path control layer OSL2 may be disposed on the display panel DP of the second display region DA2. The vertical walls VSW may extend along a first direction DR1, and arranged along a second direction DR2.

In the second display region DA2, the first-type light-emitting element ED1 may overlap the vertical walls VSW on a plane (or in plan view), and the second-type light-emitting element ED2 may not overlap the vertical walls VSW on a plane (or in plan view).

The vertical walls VSW may include first vertical walls (e.g., first vertical partition walls) VSW1 overlapping a pixel-defining film PDL, and second vertical walls (e.g., second vertical partition walls) VSW2 overlapping the first-type light-emitting element ED1.

When viewed from a driver's seat, a viewing angle AG2 of the first-type light-emitting element ED1 in the second direction DR2 may be smaller than a viewing angle AG of the second-type light-emitting element ED2 in the second direction DR2. Since the vertical walls VSW are not disposed on the second-type light-emitting element ED2, light provided from the second-type light-emitting element ED2 may have the first viewing angle AG.

Since the first vertical walls VSW1 are disposed on a pixel-defining film PDL adjacent to the first display region DA1, among the pixel-defining films PDL adjacent to the first-type light-emitting element ED1, and the second vertical walls VSW2 are disposed on the first-type light-emitting element ED1, light provided from the first-type light-emitting element ED1 may have the second viewing angle AG2 smaller than the first viewing angle AG.

In the first mode, the second-type light-emitting element ED2 may operate and have the viewing angle AG which is wide in the second direction DR2. Therefore, as illustrated in FIG. 2A, the image IM2 (see FIG. 2A) of the second display region DA2 may be viewed from the driver's seat. In the first mode, the first-type light-emitting element ED1 may or may not operate.

In case that a second mode operates, the second-type light-emitting element ED2 may not operate, and only the first-type light-emitting element ED1 may operate, and thus may have the viewing angle AG2 which is narrow in the second direction DR2. Therefore, as illustrated in FIG. 2B, the image IM2 (see FIG. 2B) of the second display region DA2 may not be viewed from the driver's seat.

FIGS. 7 to 8D illustrate that the first vertical walls VSW1 are disposed, on a plane (or in plan view), in the opposite direction of the second direction DR2 with respect to the first-type light-emitting element ED1. For example, the viewing angle AG2 of the first-type light-emitting element ED1 in the opposite direction of the second direction DR2 may be limited, and in case that only the first-type light-emitting element ED1 operates, the image IM2 of the second display region DA2 may be invisible to the driver US (see FIG. 1).

However, according to an embodiment, the arrangement of the first vertical walls VSW1 on a plane (or in plan view) is not limited thereto. For example, in case that the driver's seat is on the right side, unlike what is illustrated in FIG. 1, the first vertical walls VSW1 may be disposed in the second direction DR2 with respect to the first-type light-emitting element ED1. Thus, the second-type light-emitting element ED2 may be disposed in the opposite direction of the second direction DR2 with respect to the first-type light-emitting element ED1.

In describing with reference to FIGS. 7 to 8D, the meaning of the viewing angle being limited in the second direction DR2 may include the meaning of the viewing angle being limited in the opposite direction of the second direction DR2.

The vertical walls VSW may include a light-absorbing material or a light-blocking material. Light incident to the vertical walls VSW may be absorbed by the vertical walls VSW. A part of the light incident to the vertical walls VSW may not be absorbed, and may be reflected.

Heights VSW1-HT and VSW2-HT, widths VSW1-WD and VSW2-WD, and a distance VSW-SP of the vertical walls VSW1 and VSW2 may each vary according to the required pixel per inch (ppi) or required viewing angle AG2 of the first-type light-emitting element ED1. For example, the distance VSW-SP may refer to a narrow distance VSW-SP among the distances between the first vertical walls VSW1 and the second vertical walls VSW2.

The first transmission part TRP1 may be disposed between the vertical walls VSW. The previous description of the first transmission part TRP1 with reference to FIG. 6A may be applied to the first transmission part TRP1 disposed in the second display region DA2, except that the first transmission part TRP1 is disposed between the vertical walls VSW.

A light-collecting part LEN2-1 may be disposed on the first transmission part TRP1. The light-collecting part LEN2-1 may be disposed in a narrow region among regions between the first vertical walls VSW1 and the second vertical walls VSW2. The light-collecting part LEN2-1, disposed in the narrow region among the regions between the first vertical walls VSW1 and the second vertical walls VSW2, may be referred to as a (2-1)-th light-collecting part. On a plane (or in plan view), the narrow region, among the regions between the first vertical walls VSW1 and the second vertical walls VSW2, may correspond to a region at least partially overlapping the first-type light-emitting element ED1. On a plane (or in plan view), at least a portion of the (2-1)-th light-collecting part LEN2-1 may overlap the first-type light-emitting element ED1.

The previous description of the first light-collecting part LEN1 with reference to FIG. 6A may be applied to the (2-1)-th light-collecting part LEN2-1.

The third transmission part TRP3 may be disposed on the first transmission part TRP1. The third transmission part TRP3 may be disposed in a wide region among the regions between the first vertical walls VSW1 and the second vertical walls VSW2. On a plane (or in plan view), the wide region, among the regions between the first vertical walls VSW1 and the second vertical walls VSW2, may correspond to a region overlapping each of the first-type light-emitting element ED1 and the second-type light-emitting element ED2. On a plane (or in plan view), at least a portion of the third transmission part TRP3 may overlap the first-type light-emitting element ED1 and the second-type light-emitting element ED2. The third transmission part TRP3 and the (2-1)-th light-collecting part LEN2-1 may include the same material.

The second transmission part TRP2 may be disposed on the (2-1)-th light-collecting part LEN2-1 and the third transmission part TRP3. The contents previously described with reference to FIG. 6A may be applied to the second transmission part TRP2.

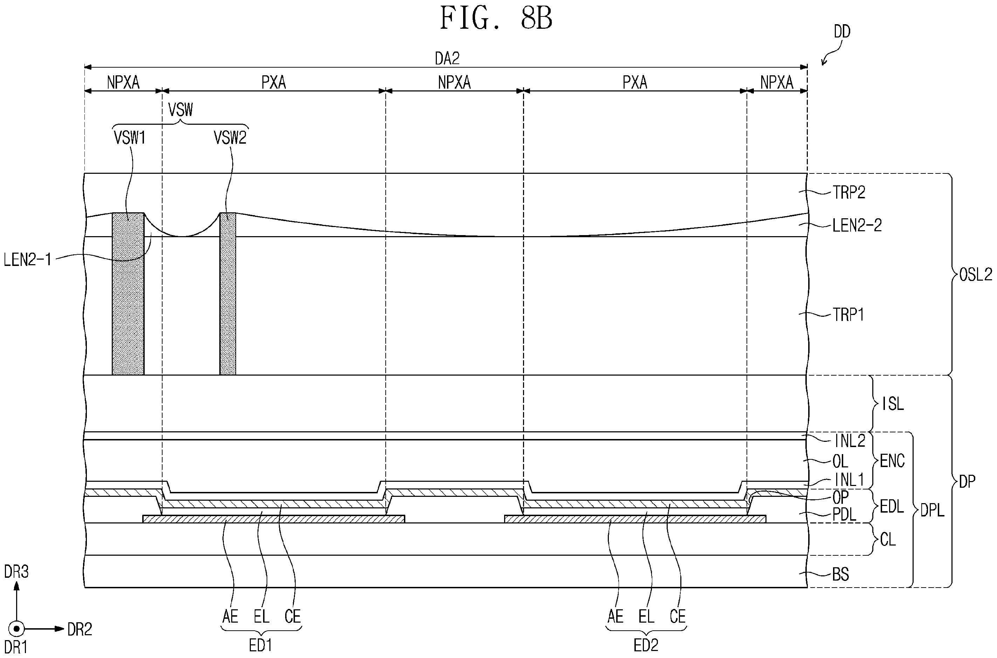

Referring to FIG. 8B, a second light-path control layer OSL2 may include a (2-1)-th light-collecting part LEN2-1 and a (2-2)-th light-collecting part LEN2-2 disposed on a first transmission part TRP1.

The (2-1)-th light-collecting part LEN2-1 may be disposed in a narrow region among regions between first vertical walls VSW1 and second vertical walls VSW2. On a plane (or in plan view), at least a portion of the (2-1)-th light-collecting part LEN2-1 may overlap a first-type light-emitting element ED1.

The (2-2)-th light-collecting part LEN2-2 may be disposed in a wide region among the regions between the first vertical walls VSW1 and the second vertical walls VSW2. Unlike in FIG. 8A, the (2-2)-th light-collecting part LEN2-2 may be disposed in the region where the third transmission part TRP3 is disposed. On a plane (or in plan view), at least a portion of the (2-2)-th light-collecting part LEN2-2 may overlap each of the first-type light-emitting element ED1 and a second-type light-emitting element ED2.

The previous description of the first light-collecting part LEN1 with reference to FIG. 6A may be applied to the (2-2)-th light-collecting part LEN2-2.

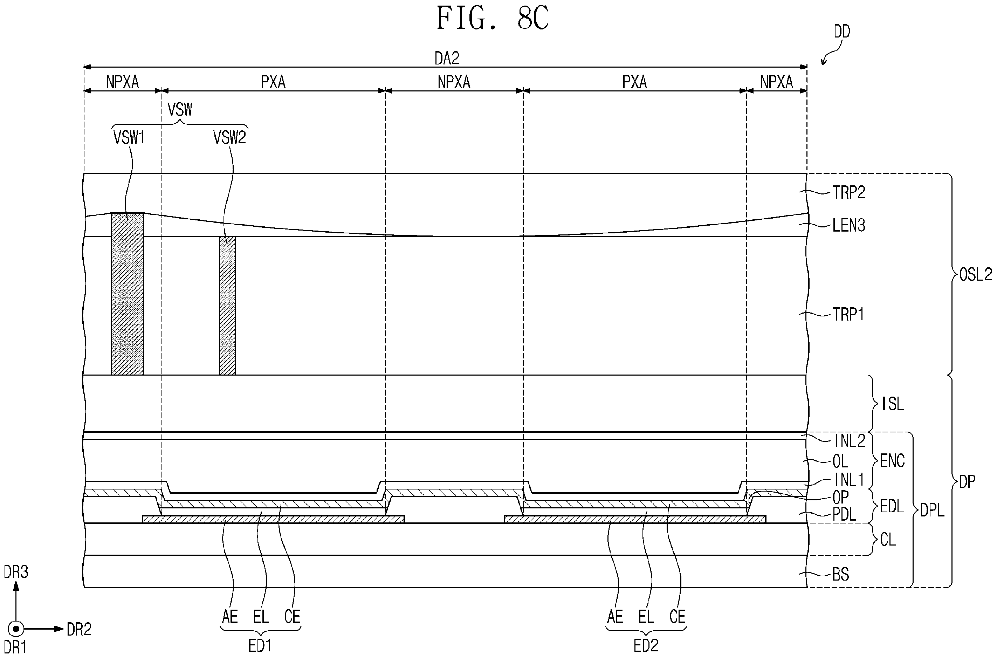

Referring to FIG. 8C, a second light-path control layer OSL2 may include a third light-collecting part LEN3. The third light-collecting part LEN3 may be disposed between the first vertical walls VSW1.

The height of the first vertical walls VSW1 and the height of second vertical walls VSW2 may be different from each other. The height of the second vertical walls VSW2 and the thickness of a first transmission part TRP1 may be the same as each other.

The third light-collecting part LEN3 may be disposed on the first transmission part TRP1 and on the second vertical walls VSW2. The third light-collecting part LEN3 may be disposed (e.g., directly disposed) on an upper surface of the first transmission part TRP1 and on upper surfaces of the second vertical walls VSW2. On a plane (or in plan view), the third light-collecting part LEN3 may overlap each of a first-type light-emitting element ED1 and a second-type light-emitting element ED2.

An upper surface of the third light-collecting part LEN3 may be concave (or recessed) in a direction toward the first transmission part TRP1. For example, the previous description of the first light-collecting part LEN1 with reference to FIG. 6A may be applied to the third light-collecting part LEN3.

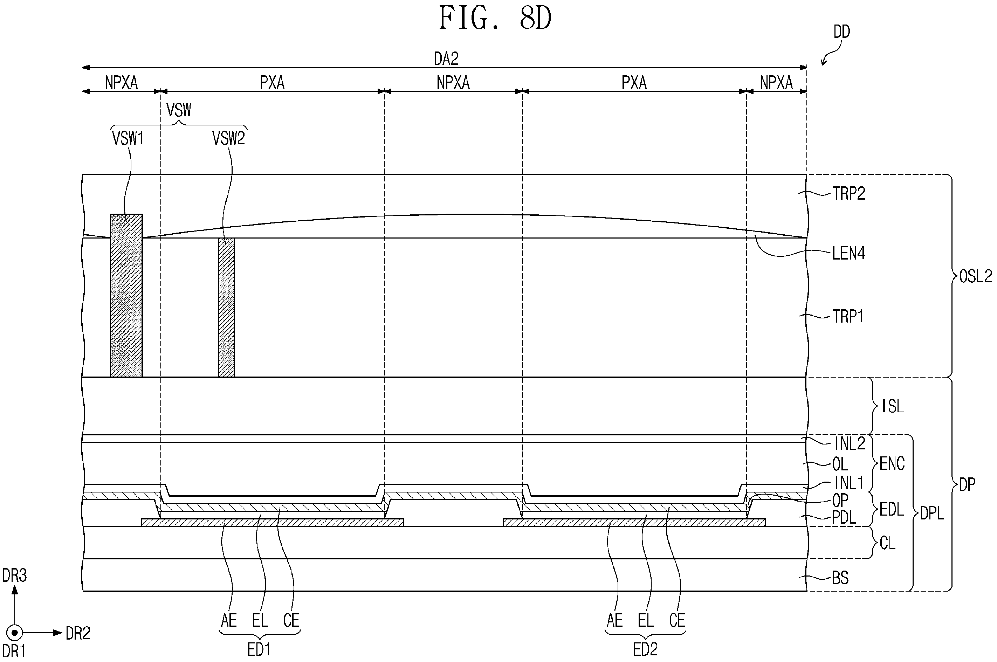

Referring to FIG. 8D, a second light-path control layer OLS2 may include a fourth light-collecting part LEN4. The fourth light-collecting part LEN4 may be disposed between first vertical walls VSW1.

The height of the first vertical walls VSW1 and the height of second vertical walls VSW2 may be different from each other. The height of the second vertical walls VSW2 and the thickness of the first transmission part TRP1 may be the same as each other.

The fourth light-collecting part LEN4 may be disposed on the first transmission part TRP1 and on the second vertical walls VSW2. The fourth light-collecting part LEN4 may be disposed (e.g., directly disposed) on an upper surface of the first transmission part TRP1 and on upper surfaces of the second vertical walls VSW2. On a plane (or in plan view), the fourth light-collecting part LEN4 may overlap each of a first-type light-emitting element ED1 and a second-type light-emitting element ED2.

An upper surface of the fourth light-collecting part LEN4 may be convex in a direction toward a second transmission part TRP2. In case that the second light-path control layer OSL2 includes the fourth light-collecting part LEN4 having the upper surface convex in the direction toward the second transmission part TRP2, as illustrated in FIG. 8D, the refractive index of the fourth light-collecting part LEN4 may be greater than the refractive index of the second transmission part TRP2. Light incident from the fourth light-collecting part LEN4 to the second transmission part TRP2 may be refracted in a third direction DR3 at the boundary surface between the fourth light-collecting part LEN4 and the second transmission part TRP2, thereby having a light-collecting effect. Accordingly, the viewing angle limitation characteristics and the front light-emitting efficiency of the second display region DA2 may be improved.

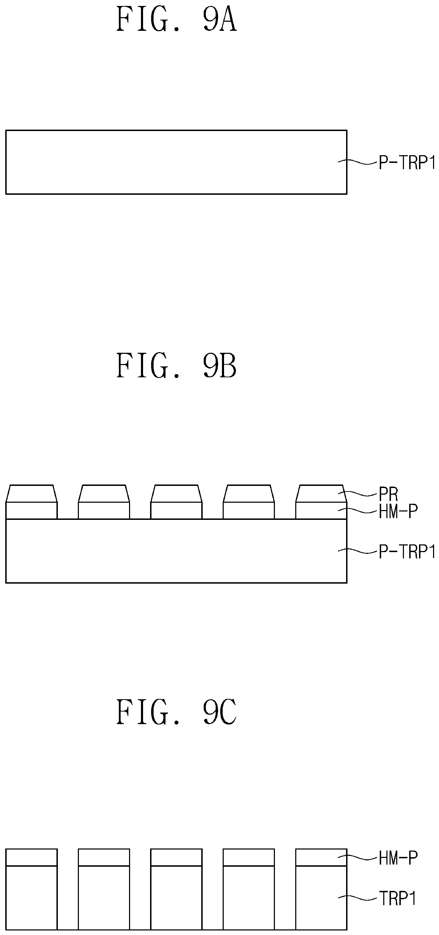

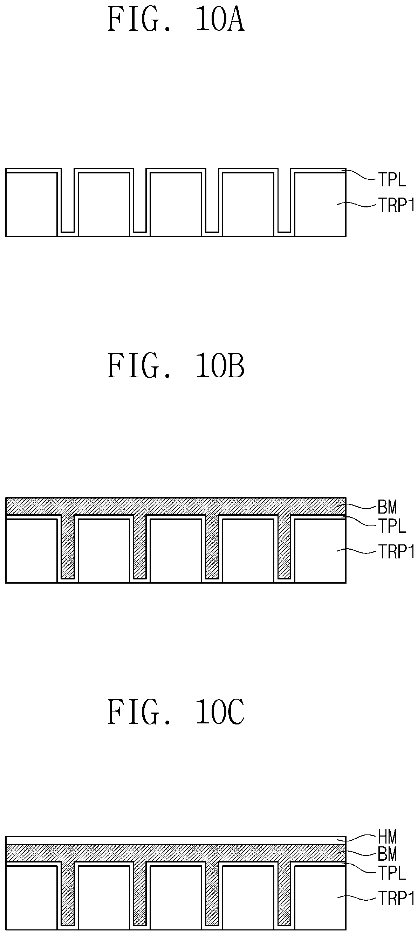

FIGS. 9A to 9H and FIGS. 10A to 10E are schematic cross-sectional views each illustrating one step of a manufacturing method of a display device according to an embodiment.

In FIGS. 9A to 9H and FIGS. 10A to 10E, the display panel DP (see FIG. 3A), included in the display device, is omitted, and each step of manufacturing the light-path control layer OSL (see FIG. 3A), to be formed on the display panel, is illustrated.

The manufacturing method of the display device according to an embodiment may include preparing a display panel, forming a first transmission part, forming light-blocking walls (e.g., light-blocking partition walls), forming a light-collecting part, and forming a second transmission part.

FIG. 9A illustrates forming a preliminary first transmission part P-TRP1 on the display panel. The display panel is omitted for descriptive convenience. The contents described with reference to FIGS. 3A to 8D may be applied to the display panel. The preliminary first transmission part P-TRP1 may be formed by applying and curing a transparent organic material. The preliminary first transmission part P-TRP1 may be formed by an inkjet coating process.

FIGS. 9B to 9D illustrate the step of forming the first transmission part TRP1 where grooves are included in the preliminary first transmission part P-TRP1. The grooves may extend in a direction and may be arranged in a direction perpendicular to the direction.

The step of forming the first transmission part TRP1 may include forming a hard mask on the entire upper surface of the preliminary first transmission part P-TRP1, patterning the hard mask by patterning a photoresist PR on the hard mask, etching the preliminary first transmission part P-TRP1, where a patterned hard mask HM-P is disposed, to form grooves, and removing the patterned hard mask HM-P.

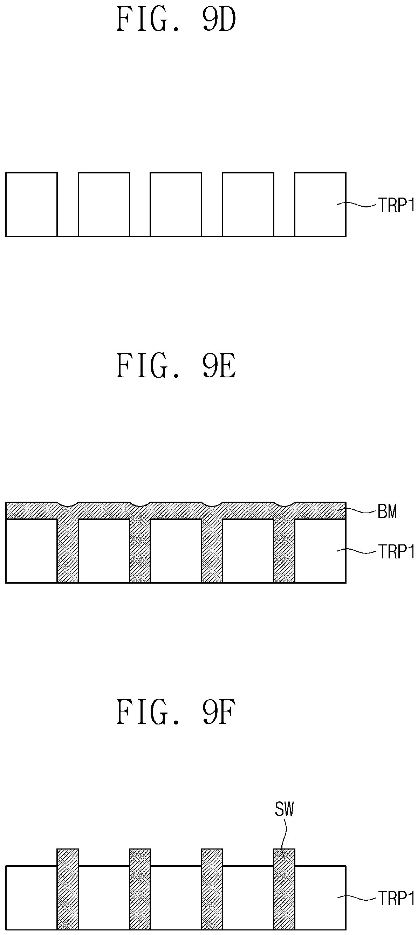

FIG. 9B illustrates a state where the hard mask is patterned on the preliminary first transmission part P-TRP1. FIG. 9C illustrates the first transmission part TRP1 having the grooves formed by etching the preliminary first transmission part P-TRP1 where the patterned hard mask HM-P is disposed. FIG. 9D illustrates the first transmission part TRP1 where the patterned hard mask HM-P is removed.

FIGS. 9E and 9F illustrate the step of forming the light-blocking walls SW. The light-blocking walls SW may be formed in a region corresponding to the grooves formed in the first transmission part TRP1. The light-blocking walls SW may correspond to the horizontal walls HSW (see FIG. 5) and the vertical walls VSW (see FIG. 7), described with reference to FIGS. 6A to 6C and FIGS. 8A to 8D, and they will be commonly referred to and described as the light-blocking walls SW.

The step of forming the light-blocking walls SW may include applying a light-blocking material BM on the first transmission part TRP1 to fill the grooves of the first transmission part TRP1, and having the light-blocking walls SW patterned.

FIG. 9E illustrates a state where the light-blocking material BM is applied on the first transmission part TRP1. The light-blocking material BM may fill the grooves defined in the first transmission part TRP1 to overcoat the upper surface of the first transmission part TRP1.

FIG. 9F illustrates a state where the light-blocking material BM is patterned to form the light-blocking walls SW. The light-blocking material BM may be patterned by a photoresist process, or through a patterned hard mask. The light-blocking material BM in a region corresponding to the grooves, defined in the first transmission part TRP1, may remain, and the light-blocking material BM in the other region may be removed, and thus the light-blocking walls SW may be formed taller than the thickness of the first transmission part TRP1. For example, the light-blocking walls SW may protrude more than the first transmission part TRP1 in the thickness direction.

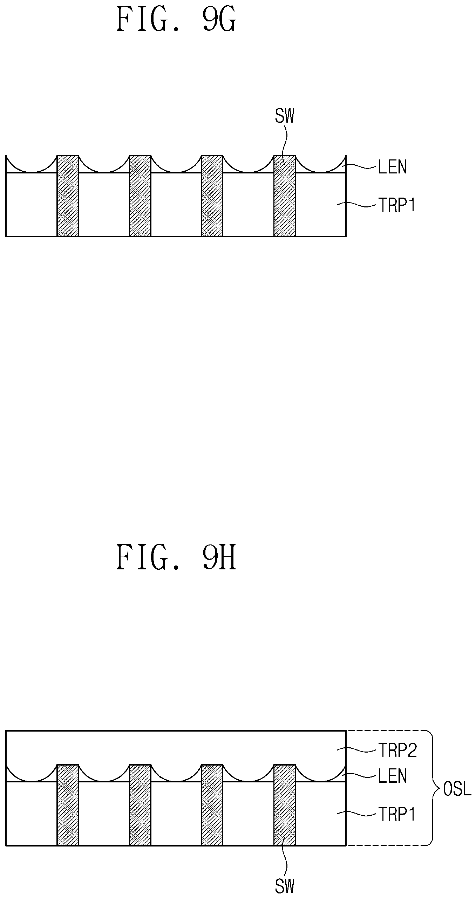

FIG. 9G illustrates the step of forming the light-collecting part LEN. The light-collecting part LEN may be formed by slit coating a transparent organic material. Since the light-blocking walls SW protrude more than the first transmission part TRP1, in case of slit coating and curing a small amount of the organic material, the light-collecting part LEN may be formed to have a concave upper surface being defined in a direction toward the first transmission part TRP1.

FIG. 9H illustrates the step of forming the second transmission part TRP2. The second transmission part TRP2 may be formed by applying and curing a transparent organic material on the light-collecting part LEN. The refractive index of the second transmission part TRP2 may be greater than the refractive index of the first transmission part TRP1. The refractive index of the second transmission part TRP2 may be greater than the refractive index of the light-collecting part LEN.

FIGS. 10A to 10E illustrate another manufacturing method of the step of forming the light-blocking walls SW in FIGS. 9E and 9F.

FIG. 10A illustrates forming a transparent protection film TPL on the first transmission part TRP1. The transparent protection film TPL may be deposited by covering the grooves defined in the first transmission part TRP1 and the upper surface of the first transmission part TRP1. The transparent protection film TPL may be deposited by sputtering or chemical vapor deposition of an inorganic material. For example, the transparent protection film TPL may include silicon oxide, silicon nitride, or a transparent conductive oxide.

FIG. 10B illustrates the step of applying the light-blocking material BM as illustrated in FIG. 9E. The light-blocking material BM may be applied on the transparent protection film TPL.

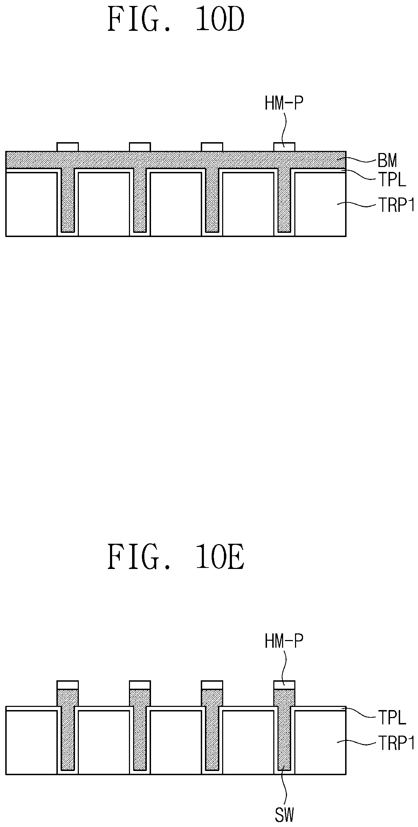

FIGS. 10C to 10E illustrate patterning the light-blocking material BM. FIG. 10C illustrates forming a hard mask HM on the light-blocking material BM. FIG. 10D illustrates forming a patterned hard mask HM-P by patterning the hard mask HM. FIG. 10E illustrates etching the light-blocking material BM to form the light-blocking walls SW.

After this, the patterned hard mask HM-P may be removed, and the light-collecting part LEN and the second transmission part TRP2 may be formed as previously described with reference to FIGS. 9G and 9H.

In the manufacturing method of the display device according to an embodiment, a chemical mechanical polishing (CMP) process is unnecessary, so that the process may be simplified and the cost may be lowered, thereby improving the process efficiency. For example, through the manufacturing method of the display device according to an embodiment, it may be possible to manufacture the display device with improved viewing angle limitation characteristics and improved front light-emitting efficiency.

A display device, according to an embodiment, may have improved viewing angle limitation characteristics and improved front light-emitting efficiency due to light-collecting effect.

In a manufacturing method of the display device, according to an embodiment, the process may be simplified and the cost may be lowered, thereby improving the process efficiency.

In concluding the detailed description, those skilled in the art will appreciate that many variations and modifications may be made to the embodiments without substantially departing from the principles and scope of the disclosure. Therefore, the disclosed embodiments are used in a generic and descriptive sense only and not for purposes of limitation.

## Claims

1. A display device comprising:
a display panel (DP); and
a light-path control layer (OSL1) disposed on the display panel to control a path of light provided from the display panel, wherein
the light-path control layer (OSL1) includes:
a plurality of horizontal walls (HSW) arranged in a first direction and extending in a second direction perpendicular to the first direction,
a first transmission part (TRP1) disposed between the plurality of horizontal walls, and having a thickness (TRP1-TK) smaller than a height of each of the plurality of horizontal walls, and
a light-collecting part (LEN1) disposed between the plurality of horizontal walls and disposed on the first transmission part, and
wherein an upper surface (LEN1-US) of the light-collecting part is concave toward the first transmission part.

2. The display device of claim 1, wherein each of the first transmission part (TRP1) and the light-collecting part (LEN1) has a refractive index of 1.4 to 1.5.

3. The display device of claim 1 or 2, further comprising:
a second transmission part (TRP2) disposed on the light-collecting part.

4. The display device of claim 3, wherein the second transmission part (TRP2) has a refractive index greater than a refractive index of the first transmission part and a refractive index of the light-collecting part.

5. The display device of claim 3 or 4, wherein the second transmission part has a refractive index of 1.55 to 1.8.

6. The display device of any of the preceding claims, further comprising:
a transparent protection film (TPL) disposed between the plurality of horizontal walls and the first transmission part and between the plurality of horizontal walls and the display panel,
wherein the transparent protection film (TPL) includes an inorganic film.

7. The display device of claim 6, wherein the transparent protection film (TPL) extends to an area between the first transmission part and the light-collecting part.

8. A display device comprising:
a display panel (DP); and
a light-path control layer (OSL2) disposed on the display panel to control a path of light provided from the display panel,
wherein the light-path control layer includes
a plurality of vertical partition walls (VSW) extending along a first direction DR1 and arranged along a second direction (DR2) perpendicular to the first direction,
a first transmission part (TRP1) disposed between the plurality of vertical partition walls, and
a light-collecting part (LEN2-1) disposed between the plurality of vertical partition walls on the first transmission part, and
wherein an upper surface of the light-collecting part is concave in a direction toward the first transmission part, or is convex in an opposite direction of the direction toward the first transmission part.

9. The display device of claim 8, wherein each of the first transmission part (TRP1) and the light-collecting part (LEN1) has a refractive index of 1.4 to 1.5.

10. The display device of claim 8 or 9, further comprising:
a second transmission part (TRP2) disposed on the light-collecting part.

11. The display device of claim 10, wherein the second transmission part (TRP2) has a refractive index greater than a refractive index of the first transmission part and a refractive index of the light-collecting part.

12. The display device of claim 10 or 11, wherein the second transmission part has a refractive index of 1.55 to 1.8.

13. A manufacturing method of a display device of any of the preceding claims, the manufacturing method comprising:
preparing a display panel (DP);
forming, on the display panel, a first transmission part (TRP1) including a plurality of grooves extending in a first direction and arranged in a second direction perpendicular to the first direction;
forming a plurality of light-blocking walls (SW) at a height higher than the first transmission part in a region corresponding to the plurality of grooves of the first transmission part;
forming a light-collecting part (LEN1, LEN2), including a concave upper surface recessed toward the first transmission part, between the plurality of light-blocking walls on the first transmission part; and
forming, on the light-collecting part, a second transmission part (TRP2) having a refractive index greater than a refractive index of the first transmission part, wherein
the forming of the plurality of light-blocking walls includes:
applying a light-blocking material on the first transmission part (TRP1) to fill the plurality of grooves, and
patterning the plurality of light-blocking walls (SW) in the region corresponding to the plurality of grooves by a photoresist process or a hard mask patterning process.

14. The manufacturing method of claim 13, further comprising:
depositing an inorganic material to form a transparent protection film covering the plurality of grooves of the first transmission part and an upper surface of the first transmission part.

15. The manufacturing method of claim 13 or 14, wherein
each of the first transmission part (TRP1) and the light-collecting part (LEN1, LEN2) has a refractive index of 1.4 to 1.5, and
the second transmission part (TRP2) has a refractive index of 1.55 to 1.8.
